(19)

**Europäisches Patentamt**
**European Patent Office**
**Office européen des brevets**

(11)　**EP 2 181 534 B1**

(12)　　　　　　**EUROPEAN PATENT SPECIFICATION**

(45) Date of publication and mention
of the grant of the patent:
**09.10.2013　Bulletin 2013/41**

(51) Int Cl.:
*H03M 13/00* (2006.01)　　　*H03M 13/35* (2006.01)
*H04L 27/26* (2006.01)

(21) Application number: **08741307.6**

(22) Date of filing: **11.04.2008**

(86) International application number:
**PCT/KR2008/002062**

(87) International publication number:
**WO 2009/011487 (22.01.2009 Gazette 2009/04)**

(54) **HIERARCHICAL MODULATION METHOD AND DEVICE**

VERFAHREN UND EINRICHTUNG ZUR HIERARCHISCHEN MODULATION

PROCÉDÉ ET DISPOSITIF DE MODULATION HIÉRARCHIQUE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **19.07.2007　KR 20070072151**

(43) Date of publication of application:
**05.05.2010　Bulletin 2010/18**

(73) Proprietor: **Electronics and Telecommunications
Research Institute
Yuseong-gu
Daejon 305-350 (KR)**

(72) Inventors:
  • **SEO, Jae Hyun
    Daejeon 305-707 (KR)**
  • **KIM, Heung Mook
    Daejeon 305-772 (KR)**
  • **KIM, Ju Yeun
    Daegu 700-412 (KR)**
  • **CHOI, Seomee
    Daejeon 305-301 (KR)**
  • **KIM, Kwang-Yong
    Daejeon 305-751 (KR)**
  • **YUN, Joung il
    Daejeon 305-308 (KR)**
  • **LEE, Gwang Soon
    Daejeon 305-770 (KR)**
  • **BAE, Jae-Hwui
    Daejeon 305-720 (KR)**
  • **YANG, Kyu Tae
    Daejeon 305-729 (KR)**

  • **KIM, Young Su
    Daejeon 301-760 (KR)**
  • **LIM, Jong Soo
    Daejeon 301-831 (KR)**
  • **LEE, Soo In
    Daejeon 302-120 (KR)**
  • **AHN, Chie teuk
    Daejeon 305-761 (KR)**

(74) Representative: **Betten & Resch
Theatinerstrasse 8
80333 München (DE)**

(56) References cited:
　　**WO-A1-01/39454　　　WO-A1-2005/020529
　　WO-A1-2007/037618　　WO-A1-2008/091102
　　KR-A- 20070 000 631**

  • **JI-HYUN KIM ET AL: "Coherent Detection for T-
    DMB Receivers in Hierarchical Modulation
    Mode", IEEE TRANSACTIONS ON CONSUMER
    ELECTRONICS, IEEE SERVICE CENTER, NEW
    YORK, NY, US, vol. 53, no. 2, 1 May 2007
    (2007-05-01), pages 294-299, XP011186738, ISSN:
    0098-3063, DOI: 10.1109/TCE.2007.381690**
  • **JI-HYUN KIM ET AL: "Detection of Hierarchically-
    Modulated Data for Advanced T-DMB Receivers",
    IEEE TRANSACTIONS ON CONSUMER
    ELECTRONICS, IEEE SERVICE CENTER, NEW
    YORK, NY, US, vol. 54, no. 1, 1 February 2008
    (2008-02-01), pages 39-46, XP011225500, ISSN:
    0098-3063, DOI: 10.1109/TCE.2008.4470021**

## Description

### Technical Field

The present invention relates to a hierarchical modulation method and device. Particularly, the present invention relates to a hierarchical modulation method and device based on the orthogonal frequency division multiplexing (OFDM) scheme.

This work was supported by the IT R&D program of MIC/ IITA [2006- S- 107- 02, Development of advanced transmission technology for the terrestrial DMB system] .

### Background Art

Hierarchical modulation is a method for transmitting a plurality of independent signals by modulating at least two independent signals that are modulated by different modulation methods into a single signal.

A base layer signal in the hierarchical modulation is a signal transmitted to the conventional system, and an enhancement layer signal is a signal for providing an additional service to the base layer signal. When the hierarchically modulated signal is transmitted, receiving performance of the enhancement layer signal is worse than receiving performance of the base layer signal.

The above information disclosed in this Background section is only for enhancement of understanding of the background of the invention and therefore it may contain information that does not form the prior art that is already known in this country to a person of ordinary skill in the art.

JI- HYUN KIM ET AL: "Coherent Detection for T- DMB Receivers in Hierarchical Modulation Mode", IEEE TRANSACTIONS ON CONSUMER ELECTRONICS, IEEE SERVICE CENTER, NEW YORK, NY, US, vol. 53, no. 2, 1 May 2007 (2007- 05- 01), pages 294- 299, discloses hierarchical modulation for achieving higher data rates in T- DMB systems which makes use a decision- directed channel estimation method for the coherent detection of phase correction. The decision- directed channel estimation method performs least- squares channel estimation being carried out with hard- decision symbols due to the absence of known pilots and then exponentially averaging the estimated coefficients using a forgetting factor to compensate for the probable inaccuracy of the instantaneous estimation.

### Disclosure of Invention

#### Technical Problem

The present invention has been made in an effort to provide a hierarchical modulation method and device for improving receiving performance of an enhancement layer signal without influencing a base layer signal when receiving a hierarchically modulated signal.

#### Technical Solution

The present invention is defined in the independent claims. The dependent claims define embodiments.

In one aspect of the present invention, a hierarchical modulation method includes: generating a plurality of first hierarchical modulation symbols by modulating a plurality of the first hierarchical symbols according to a first modulation method; generating a plurality of pilot insertion symbols by inserting a plurality of pilot symbols into a plurality of second hierarchical symbols; generating a plurality of second hierarchical modulation symbols by modulating the plurality of pilot insertion symbols according to a second modulation method; and generating a plurality of hierarchical modulation symbols by mapping the plurality of first hierarchical modulation symbols and the plurality of second hierarchical modulation symbols in a signal space.

The method further includes generating a plurality of normalized hierarchical modulation symbols that correspond to the plurality of hierarchical modulation symbols by applying a normalization constant to the plurality of hierarchical modulation symbols.

The step of generating the plurality of pilot insertion symbols includes inserting the plurality of pilot symbols into the plurality of second hierarchical symbols so that a pilot symbol may be provided at a position having the greatest power from among the plurality of hierarchical modulation symbols.

The step of generating the plurality of normalized hierarchical modulation symbol includes generating a plurality of normalized hierarchical modulation symbols by applying a normalization constant that corresponds to the hierarchical modulation level of the plurality of hierarchical modulation symbols to the plurality of hierarchical modulation symbols.

The second modulation method is the same as the first modulation method.

The method further includes generating the plurality of first hierarchical symbols by encoding a plurality of bits included in the first hierarchical signal sequence according to a first encoding method.

The method further includes generating the plurality of second hierarchical symbols by encoding a plurality of bits included in the second hierarchical signal sequence according to a second encoding method.

The plurality of first hierarchical symbols are a plurality of base layer symbols that are generated by encoding a plurality of bits included in the base layer signal, and the plurality of second hierarchical symbols are a plurality of enhancement layer symbols that are generated by encoding a plurality of bits included in the enhancement layer signal for providing a service added to the base layer signal.

In another aspect of the present invention, a hierarchical modulation device includes a first hierarchical channel encoder, a second hierarchical channel encoder, a pilot inserter, and a hierarchical modulator. The first hierarchical channel encoder outputs a first hierarchical symbol sequence by encoding the first hierarchical signal sequence according to a first encoding method. The second hierarchical channel encoder outputs a second hierarchical symbol sequence by encoding the second hierarchical signal sequence according to a second encoding method. The pilot inserter outputs a pilot insertion symbol sequence by inserting a pilot symbol into the second hierarchical symbol sequence. The hierarchical modulator outputs a hierarchical modulation signal by performing hierarchical modulation on the first hierarchical symbol sequence and the pilot insertion symbol sequence.

The device further includes a hierarchical modulation level controller for outputting a normalization constant corresponding to a hierarchical modulation level, and the hierarchical modulator outputs a normalized hierarchical modulation signal by performing hierarchical modulation on the first hierarchical symbol sequence and the pilot insertion symbol sequence based on the normalization constant.

The hierarchical modulator includes a first hierarchical modulator for outputting a first hierarchical modulation symbol sequence by modulating the first hierarchical symbol sequence according to a first modulation method; a second hierarchical modulator for outputting a second hierarchical modulation symbol sequence by modulating the pilot insertion symbol sequence according to a second modulation method; a symbol mapper for outputting a hierarchical modulation signal by mapping the first hierarchical modulation symbol sequence and the second hierarchical modulation symbol sequence in the signal space; and a normalizer for outputting a normalized hierarchical modulation signal by applying the normalization constant to the hierarchical modulation signal.

The first hierarchical signal sequence is a base layer signal sequence, and the second hierarchical signal sequence is an enhancement layer signal sequence for providing a service added to the base layer signal sequence.

## Advantageous Effects

Receiving performance of the enhancement layer can be improved by inserting a pilot symbol in the enhancement layer without influencing the base layer.

## Brief Description of the Drawings

FIG. 1 is a block diagram of a hierarchical modulation device according to an exemplary embodiment of the present invention.

FIG. 2 is a block diagram of a hierarchical modulator according to an exemplary embodiment of the present invention.

FIG. 3 is a block diagram of a demodulation device according to an exemplary embodiment of the present invention.

FIG. 4 is a flowchart for a hierarchical modulation method according to an exemplary embodiment of the present invention.

FIG. 5 is a constellation diagram for a hierarchical modulation signal output by a symbol mapper according to an exemplary embodiment of the present invention.

FIG. 6 shows normalization constants for hierarchical modulation levels according to an exemplary embodiment of the present invention.

FIG. 7 is a pilot layout view for a transmission frame including a hierarchical modulation signal according to an exemplary embodiment of the present invention.

FIG. 8 is a flowchart for a hierarchical modulation signal demodulating method according to an exemplary embodiment of the present invention.

## Mode for the Invention

In the following detailed description, only certain exemplary embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

Throughout this specification and the claims which follow, unless explicitly described to the contrary, the word "comprising" and variations such as "comprises" will be understood to imply the inclusion of stated elements but not the exclusion of any other elements. Also, the terms of a unit, a device, and a module in the present specification represent a unit for processing a predetermined function or operation, which can be realized by hardware, software, or a combination of hardware and software.

A hierarchical modulation method and device and a hierarchical demodulation method and device according to an exemplary embodiment of the present invention will now be described with reference to the drawings.

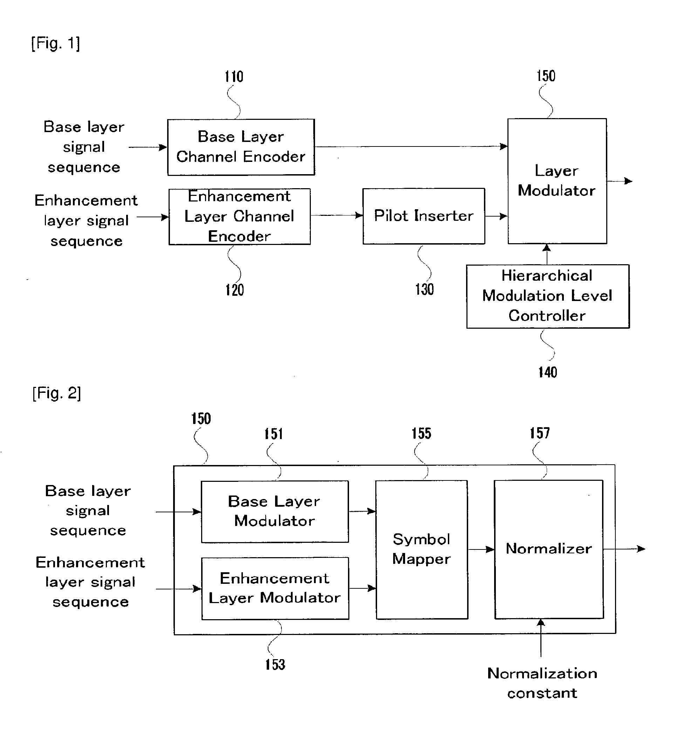

A hierarchical modulation device according to an exemplary embodiment of the present invention will now be described with reference to FIG. 1.

FIG. 1 is a block diagram for a hierarchical modulation device according to an exemplary embodiment of the present invention.

As shown in FIG. 1, the hierarchical modulation device includes a base layer channel encoder 110, an enhancement layer channel encoder 120, a pilot inserter 130, a hierarchical modulation level controller 140, and a hierarchical modulator 150.

The base layer channel encoder 110 receives a base layer signal sequence including a plurality of bits, and encodes the base layer signal sequence to output a base layer symbol sequence. That is, the base layer channel encoder 110 encodes a plurality of bits included in the base layer signal sequence to output a base layer symbol sequence including a plurality of base layer symbols. In this instance, the base layer channel encoder 110 can encode the base layer signal sequence by using convolutional encoding, lattice encoding, turbo encoding, low density parity check (LDPC) encoding, or concatenated encoding of at least two of the above encoding methods.

The enhancement layer channel encoder 120 receives the enhancement layer signal sequence including a plurality of bits, and encodes the enhancement layer signal sequence to output an enhancement layer symbol sequence. That is, the enhancement layer channel encoder 120 encodes a plurality of bits included in the enhancement layer signal sequence to output an enhancement layer symbol sequence including a plurality of enhancement layer symbols. In this instance, the enhancement layer channel encoder 120 can encode the enhancement layer signal sequence by using convolution encoding, lattice encoding, turbo encoding, low density parity check (LDPC) encoding, or concatenated encoding of at least two of the above encoding methods.

The pilot inserter 130 receives an enhancement layer symbol sequence from the enhancement layer channel encoder 120, and inserts a pilot symbol into the enhancement layer symbol sequence to output a pilot insertion symbol sequence. That is, the pilot inserter 130 inserts a plurality of pilot symbols to a plurality of enhancement layer symbols to output a pilot insertion symbol sequence including a plurality of pilot insertion symbols. In this instance, the pilot inserter 130 can insert a pilot symbol and output an enhancement layer signal according to a pilot arrangement method. Further, the pilot arrangement method can be predefined.

The hierarchical modulation level controller 140 outputs a normalization constant for controlling the hierarchical modulation level. In this instance, the hierarchical modulation level can be predefined. Also, the normalization constant following the hierarchical modulation level can be predefined.

The hierarchical modulator 150 receives a base layer symbol sequence from the base layer channel encoder 110 and receives a pilot insertion symbol sequence from the pilot inserter 130 to perform hierarchical modulation on the base layer symbol sequence and the pilot insertion symbol sequence and output a hierarchical modulation signal. That is, the hierarchical modulator 150 performs hierarchical modulation on a plurality of base layer symbols and a plurality of pilot insertion symbols to output a hierarchical modulation signal including a plurality of hierarchical modulation symbols. The hierarchical modulator 150 can perform hierarchical modulation on the base layer symbol sequence and the pilot insertion symbol sequence based on the normalization constant. In this instance, the hierarchical modulator 150 can receive the normalization constant from the hierarchical modulation level controller 140.

A hierarchical modulator of the hierarchical modulation device according to an exemplary embodiment of the present invention will now be described with reference to FIG. 2.

FIG. 2 is a block diagram of a hierarchical modulator according to an exemplary embodiment of the present invention.

As shown in FIG. 2, the hierarchical modulator 150 includes a base layer modulator 151, an enhancement layer modulator 153, a symbol mapper 155, and a normalizer 157.

The base layer modulator 151 receives a base layer symbol sequence from the base layer channel encoder 110, and modulates the base layer symbol sequence to output a base layer modulation symbol sequence. That is, the base layer modulator 151 modulates a plurality of base layer symbols to output a base layer modulation symbol sequence including a plurality of base layer modulation symbols. In this instance, the base layer modulator 151 can modulate the base layer symbol sequence by using the $\pi/4$- differential quadrature phase- shift keying ($\pi/4$- DQPSK) scheme.

The enhancement layer modulator 153 receives a pilot insertion symbol sequence from the pilot inserter 130, and modulates the pilot insertion symbol sequence to output an enhancement layer modulation symbol sequence. That is, the enhancement layer modulator 153 modulates a plurality of pilot insertion symbols to output an enhancement layer modulation symbol sequence including a plurality of enhancement layer modulation symbols. In this instance, the enhancement layer modulator 153 can modulate the pilot insertion symbol sequence by using the $\pi/4$-DQPSK scheme. Also, the enhancement layer modulator 153 can modulate the pilot insertion symbol sequence by using amplitude shift keying (ASK) or the quadrature amplitude modulation (QAM). The enhancement layer modulator 153 can modulate the pilot insertion symbol sequence by using various modulation schemes according to propagation environments and data rates.

The symbol mapper 155 receives a base layer modulation symbol sequence from the base layer modulator 151 and receives an enhancement layer modulation symbol sequence from the enhancement layer modulator 153 to map the base layer modulation symbol sequence and the enhancement layer modulation symbol sequence in the signal space and output a hierarchical modulation signal. That is, the symbol mapper 155 maps a plurality of base layer modulation symbols and a plurality of enhancement layer modulation symbols in the signal space to output a hierarchical modulation signal including a plurality of hierarchical modulation symbols.

The normalizer 157 receives the hierarchical modulation signal from the symbol mapper 155, and normalizes the hierarchical modulation signal to output the normalized hierarchical modulation signal. The normalizer 157 applies a normalization constant to a plurality of hierarchical modulation symbols to output a normalized hierarchical modulation signal including a plurality of normalized hierarchical modulation symbols. The normalizer 157 can receive a normalization constant from the hierarchical modulation level controller 140.

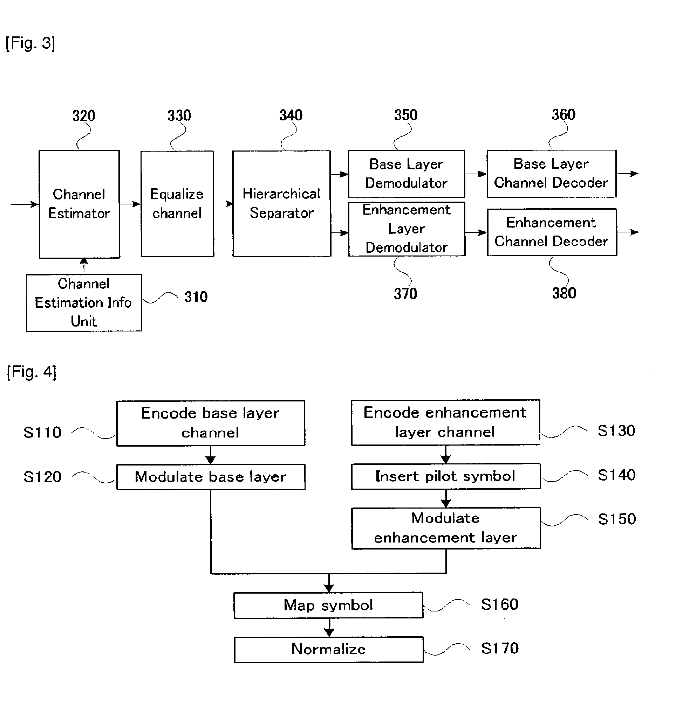

A demodulation device according to an exemplary embodiment of the present invention will now be described with reference to FIG. 3.

FIG. 3 is a block diagram for a demodulation device according to an exemplary embodiment of the present invention.

As shown in FIG. 3, the demodulation device includes a channel estimation information unit 310, a channel estimator 320, a channel equalizer 330, a hierarchical separator 340, a base layer demodulator 350, a base layer channel decoder 360, an enhancement layer demodulator 370, and an enhancement layer channel decoder 380.

The channel estimation information unit 310 outputs channel estimation information. In this instance, the channel estimation information can include pilot position information and hierarchical modulation level information.

The channel estimator 320 receives the hierarchical modulation signal, and performs channel estimation on the hierarchical modulation signal to output a channel response. The channel estimator 320 can output a channel response to the hierarchical modulation signal based on the channel estimation information. In this instance, the channel estimator 320 can output a hierarchical modulation signal together with the channel response.

The channel equalizer 330 receives the hierarchical modulation signal and the channel response from the channel estimator 320, and performs channel equalization on the hierarchical modulation signal according to the channel response to output a channel-equalized hierarchical modulation signal.

The hierarchical separator 340 receives the channel equalized hierarchical modulation signal from the channel equalizer 330, and separates the channel equalized hierarchical modulation signal to output a base layer modulation signal and an enhancement layer modulation signal.

The base layer demodulator 350 receives the base layer modulation signal from the hierarchical separator 340, and demodulates the base layer modulation signal to output a base layer signal.

The base layer channel decoder 360 receives the base layer signal from the base layer demodulator 350, and performs channel decoding on the base layer signal to output a base layer signal sequence.

The enhancement layer demodulator 370 receives the enhancement layer modulation signal from the hierarchical separator 340, and demodulates the enhancement layer modulation signal to output an enhancement layer signal.

The enhancement layer channel decoder 380 receives the enhancement layer signal from the enhancement layer demodulator 370, and performs channel decoding on the enhancement layer signal to output an enhancement layer signal sequence.

A method for a hierarchical modulation device to perform hierarchical modulation according to an exemplary embodiment of the present invention will now be described with reference to FIG. 4.

FIG. 4 is a flowchart for a hierarchical modulation method according to an exemplary embodiment of the present invention.

As shown in FIG. 4, the base layer channel encoder 110 encodes the base layer signal sequence to generate a base layer symbol sequence (S110). In this instance, the base layer channel encoder 110 can encode the base layer signal sequence through a predetermined encoding scheme.

The base layer modulator 151 of the hierarchical modulator 150 modulates the base layer symbol sequence to generate a base layer modulation symbol sequence (S120). In this instance, the base layer modulator 151 can modulate the base layer symbol sequence through a predetermined modulation scheme.

The enhancement layer channel encoder 120 encodes the enhancement layer signal sequence to generate an enhancement layer symbol sequence (S 130). In this instance, the enhancement layer channel encoder 120 can encode the enhancement layer signal sequence through a predetermined encoding scheme.

The pilot inserter 130 inserts a pilot symbol to the enhancement layer symbol sequence to generate a pilot insertion symbol sequence (S140). In this instance, the position of inserting the pilot can be predefined.

The enhancement layer modulator 153 of the hierarchical modulator 150 modulates the pilot insertion symbol sequence to generate an enhancement layer modulation symbol sequence (S 150). In this instance, the enhancement layer modulator 153 can modulate the pilot insertion symbol sequence through a predetermined modulation scheme. Also, the enhancement layer modulator 153 can modulate the pilot insertion symbol sequence through the same modulation scheme as the base layer modulator 151.

The symbol mapper 155 of the hierarchical modulator 150 maps the base layer modulation symbol sequence and the enhancement layer modulation symbol sequence in the signal space to generate a hierarchical modulation signal (S160).

The normalizer 157 of the hierarchical modulator 150 normalizes the hierarchical modulation signal to generate a normalized hierarchical modulation signal (S170). In this instance, the normalizer 157 can apply a normalization constant that corresponds to the hierarchical modulation level of the hierarchical modulation signal to the hierarchical modulation signal. Also, the hierarchical modulation level of the hierarchical modulation signal can be predefined.

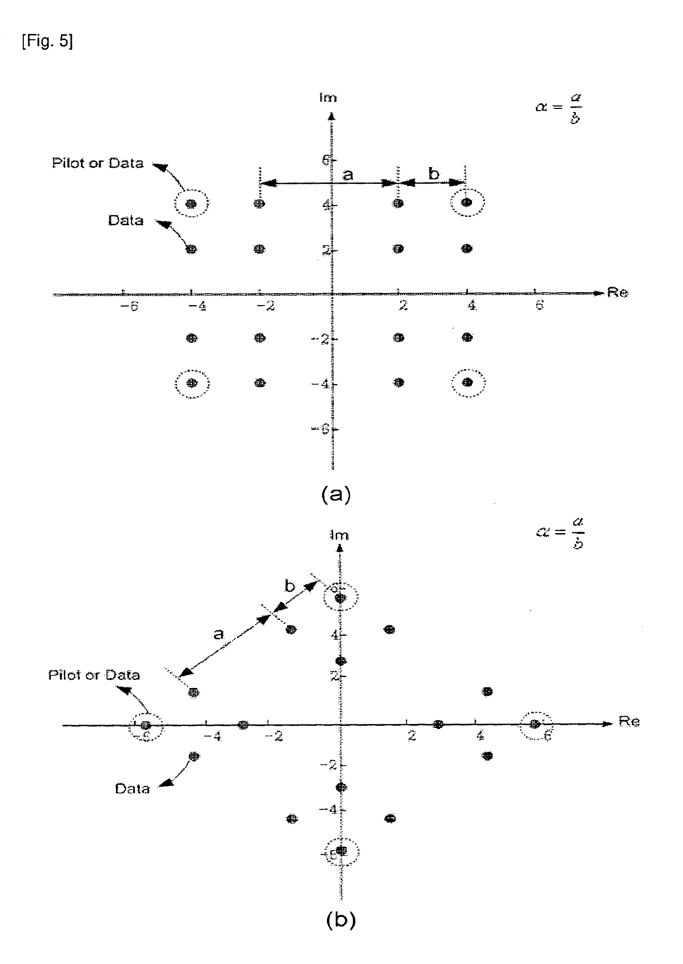

A constellation of a hierarchical modulation signal output by a symbol mapper of a hierarchical modulator according to an exemplary embodiment of the present invention will now be described with reference to FIG. 5.

FIG. 5 is a constellation diagram for a hierarchical modulation signal output by a symbol mapper according to an exemplary embodiment of the present invention. In FIG. 5, (a) is a constellation for odd-numbered symbols of a hierarchical modulation signal, and (b) is a constellation for even--numbered symbols of a hierarchical modulation signal.

As shown in FIG. 5 (a) and FIG. 5 (b), the odd-numbered symbols and the even-numbered symbols have a phase difference of $\pi/4$, and hence, the odd-numbered symbols will be described.

In this instance, the base layer modulation symbol sequence ($z_{HP}$) is modulated by the $\pi/4$-DQPSK scheme, and is expressed in Equation 1.

$$(\text{Equation 1})$$

$$z_{HP} = x_{HP} + jy_{HP}$$

In Equation 1, $x_{HP}$ and $y_{HP}$ respectively have a level of -3 and +3.

Also, the enhancement layer modulation symbol sequence ($z_{LP}$) is modulated by the $\pi/4$- DQPSK scheme, and is expressed in Equation 2.

$$(\text{Equation 2})$$

$$z_{LP} = x_{LP} + jy_{LP}$$

In Equation 2, $x_{LP}$ and $y_{LP}$ respectively have a level of -1 and +1.

As shown in FIG. 5, when the base layer modulation symbol sequence ($z_{HP}$) follows Equation 1 and the enhancement layer modulation symbol sequence ($z_{LP}$) follows Equation 2, the hierarchical modulation signal (z) is expressed in Equation 3.

$$(\text{Equation 3})$$

$$z = z_{HP} + z_{LP} = (x_{HP} + x_{LP}) + j(y_{HP} + y_{LP})$$

The hierarchical modulation signal (z) has levels of -4, -2, +2, and +4 according to Equation 3.

When the hierarchical modulation signal (z) follows Equation 3, the hierarchical modulation level ($\alpha$) is expressed in Equation 4.

$$(\text{Equation 4})$$

$$\alpha = \frac{a}{b}$$

In Equation 4, a represents the distance to the nearest constellation in the different quadrants, and b represents the distance to the nearest constellation in the same quadrants.

Also, the pilot symbol indicated as dotted lines in FIG. 5 (a) and FIG. 5 (b) represents the position of the pilot symbol inserted into the enhancement layer signal in the constellation. The pilot symbol can be inserted into the position having the greatest power in the constellation of the hierarchical modulation signal. The pilot symbol can be inserted into the position that is the farthest from the origin of the constellation of the hierarchical modulation signal.

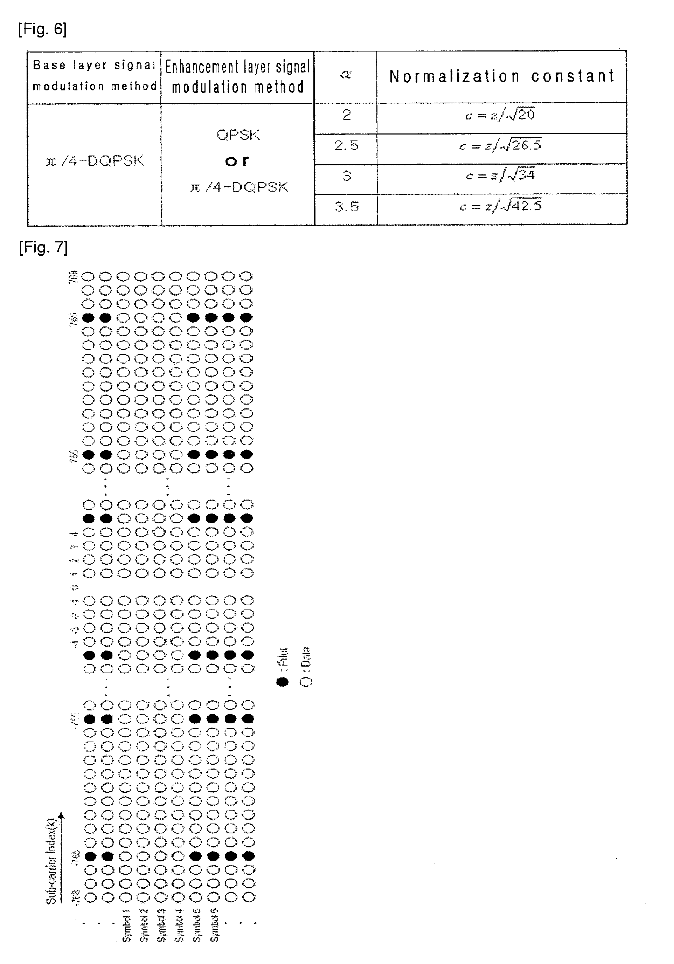

A normalization constant that corresponds to a hierarchical modulation level according to an exemplary embodiment of the present invention will now be described with reference to FIG. 6.

FIG. 6 shows normalization constants for hierarchical modulation levels according to an exemplary embodiment of the present invention.

As shown in FIG. 6, c represents the normalized hierarchical modulation signal, and z indicates the hierarchical modulation signal.

The hierarchical modulation level controller 140 applies the normalization constant that corresponds to the hierarchical modulation level ($\alpha$) of the hierarchical modulation signal to the hierarchical modulation signal (z) to output the normalized hierarchical modulation signal (c).

In this instance, the normalization constant is a value such that the normalized hierarchical modulation signal (c) satisfies Equation 5.

$$(\text{Equation 5})$$

$$E\left\{c \cdot c^{*}\right\} = 1$$

A method for arranging a pilot symbol included in a hierarchical modulation signal according to an exemplary embodiment of the present invention will now be described with reference to FIG. 7.

FIG. 7 is a pilot layout view for a transmission frame including a hierarchical modulation signal according to an exemplary embodiment of the present invention.

As shown in FIG. 7, the horizontal axis represents the subcarrier number and the vertical axis indicates the number of the OFDM symbol.

A single transmission frame includes 76 OFDM symbols. In this instance, the OFDM symbol 1 represents a phase reference symbol (PRS) of a synchronization channel, the OFDM symbols 2 to 4 indicate fast information channels (FIC), and the OFDM symbols 5 to 76 indicate main service channels (MSC).

The pilot symbol is inserted into the OFDM symbol of the MSC excluding the PRS and the FIC, and is arranged to subcarriers with regular intervals. FIG. 4 shows a case of inserting 10% of subcarriers as pilot symbols, in which 154 pilot symbols from the - 765-th subcarrier to the 765-th subcarrier at intervals of 10 are positioned. The subcarrier number k has the range from -768 to 768, and no data are inserted into the subcarrier 0. In this instance, the subcarrier number $k_p$ in which the pilot symbol is positioned in the OFDM symbol corresponding to the MSC in the transmission frame is expressed in Equation 6.

$$(\text{Equation 6})$$

$$k_p = k_{offset} + \Delta \cdot n$$

In Equation 6, $k_{offset}$ represents the subcarrier number of the first pilot symbol, $\Delta$ is the difference of the subcarrier number between pilot symbols, and n is an integer having a value within the range of the subcarrier number. In this instance, in FIG. 4, k $_{offset}$ is -765, $\Delta$ is 10, and n has a value from 0 to 153.

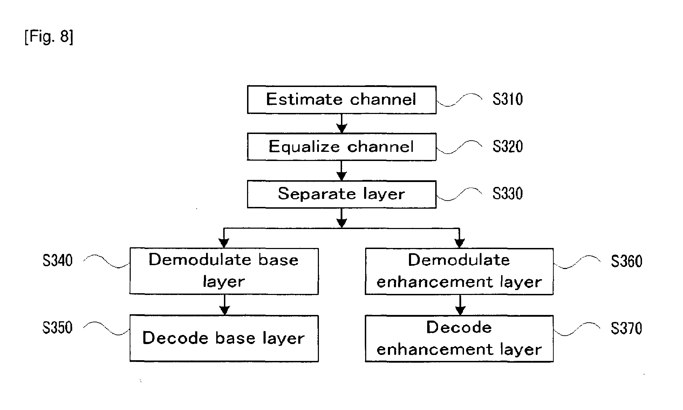

A method for a demodulation device to demodulate a hierarchical modulation signal according to an exemplary embodiment of the present invention will now be described with reference to FIG. 8.

FIG. 8 is a flowchart for a hierarchical modulation signal demodulating method according to an exemplary embodiment of the present invention.

As shown in FIG. 8, the channel estimator 320 estimates the channel for the hierarchical modulation signal transmitted through the channel to generate a channel response (S310). In this instance, the channel estimator 320 can generate the channel response based on channel estimation information output by the channel estimation information unit 310.

The channel equalizer 330 performs channel equalization on the hierarchical modulation signal according to the channel response to generate a channel equalized hierarchical modulation signal (S320).

The hierarchical separator 340 separates the channel equalized hierarchical modulation signal for respective layers to generate a base layer modulation signal and an enhancement layer modulation signal (S330).

The base layer demodulator 350 demodulates the base layer modulation signal to generate a base layer signal (S340). In this instance, the base layer demodulator 350 can demodulate the base layer signal according to a predetermined demodulation scheme.

The base layer channel decoder 360 decodes the base layer signal to generate a base layer signal sequence (S350). The base layer channel decoder 360 can decode the base layer signal according to a predetermined decoding scheme.

The enhancement layer demodulator 370 generates an enhancement layer signal by demodulating the enhancement layer modulation signal (S360). In this instance, the enhancement layer demodulator 370 can demodulate the enhancement layer signal according to a predetermined demodulation scheme.

The enhancement layer channel decoder 380 decodes the enhancement layer signal to generate an enhancement layer signal sequence (S370). The enhancement layer channel decoder 380 can decode the enhancement layer signal according to a predetermined decoding scheme.

The above-described embodiments can be realized through a program for realizing functions corresponding to the configuration of the embodiments or a recording medium for recording the program in addition to through the above-described device and/or method, which is easily realized by a person skilled in the art.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

**1.** A hierarchical modulation method comprising:

generating a plurality of first hierarchical modulation symbols by modulating a plurality of the first hierarchical symbols (S120) according to a first modulation method;
generating a plurality of pilot insertion symbols by inserting a plurality of pilot symbols into a plurality of second hierarchical symbols (S140);
generating a plurality of second hierarchical modulation symbols by modulating the plurality of pilot insertion symbols (S150) according to a second modulation method; and
generating a plurality of hierarchical modulation symbols by mapping the plurality of first hierarchical modulation symbols and the plurality of second hierarchical modulation symbols in a signal space (S160),
the hierarchical modulation method further comprising generating a plurality of normalized hierarchical modulation symbols (S170) that correspond to the plurality of hierarchical modulation symbols by applying a normalization constant to the plurality of hierarchical modulation symbols,
wherein the plurality of first hierarchical symbols are a plurality of base layer symbols that are generated by encoding a plurality of bits included in the base layer signal, and the plurality of second hierarchical symbols are a plurality of enhancement layer symbols that are generated by encoding a plurality of bits included in the enhancement layer signal for providing a service added to the base layer signal.

**2.** The hierarchical modulation method of claim 1, wherein the step of generating the plurality of pilot insertion symbols includes inserting the plurality of pilot symbols into the plurality of second hierarchical symbols (S150) so that a pilot symbol is provided at the position having the greatest power from among the plurality of hierarchical modulation symbols.

3. The hierarchical modulation method of claim 1, wherein the step of generating the plurality of normalized hierarchical modulation symbols (S170) includes generating a plurality of normalized hierarchical modulation symbols by applying the normalization constant that corresponds to the hierarchical modulation level of the plurality of hierarchical modulation symbols to the plurality of hierarchical modulation symbols.

4. The hierarchical modulation method of claim 1, wherein the second modulation method is the same as the first modulation method or is a phase shift keying method.

5. The hierarchical modulation method of claim 1, further comprising generating the plurality of first hierarchical symbols by encoding a plurality of bits included in the first hierarchical signal sequence according to a first encoding method.

6. The hierarchical modulation method of claim 1, further comprising generating the plurality of second hierarchical symbols by encoding a plurality of bits included in the second hierarchical signal sequence according to a second encoding method.

7. A hierarchical modulation device comprising:

a first hierarchical channel encoder (110) for outputting a first hierarchical symbol sequence by encoding the first hierarchical signal sequence according to a first encoding method;
a second hierarchical channel encoder (120) for outputting a second hierarchical symbol sequence by encoding the second hierarchical signal sequence according to a second encoding method;
a pilot inserter (130) for outputting a pilot insertion symbol sequence by inserting a pilot symbol into the second hierarchical symbol sequence; and
a hierarchical modulator (150) for outputting a hierarchical modulation signal by performing hierarchical modulation on the first hierarchical symbol sequence and the pilot insertion symbol sequence,
the hierarchical modulation device further including a hierarchical modulation level controller (140) for outputting a normalization constant corresponding to a hierarchical modulation level,
wherein the hierarchical modulator (150) is adapted to output a normalized hierarchical modulation signal by performing hierarchical modulation on the first hierarchical symbol sequence and the pilot insertion symbol sequence based on the normalization constant, and
wherein the first hierarchical symbol sequence is a base layer symbol sequence that is generated by encoding a plurality of bits included in the base layer signal, and the second hierarchical symbol sequence is an enhancement layer symbol sequence that is generated by encoding a plurality of bits included in the enhancement layer signal for providing a service added to the base layer signal.

8. The hierarchical modulation device of claim 7, wherein the hierarchical modulator (150) includes:

a first hierarchical modulator (151) for outputting a first hierarchical modulation symbol sequence by modulating the first hierarchical symbol sequence according to a first modulation method;
a second hierarchical modulator (153) for outputting a second hierarchical modulation symbol sequence by modulating the pilot insertion symbol sequence according to a second modulation method;
a symbol mapper (155) for outputting a hierarchical modulation signal by mapping the first hierarchical modulation symbol sequence and the second hierarchical modulation symbol sequence in the signal space; and
a normalizer (157) for outputting the normalized hierarchical modulation signal by applying the normalization constant to the hierarchical modulation signal.

**Patentansprüche**

1. Verfahren zur hierarchischen Modulation, umfassend:

Erzeugen einer Vielzahl von ersten Hierarchische-Modulation-Symbolen durch Modulieren einer Vielzahl der ersten hierarchischen Symbole (S120) in Übereinstimmung mit einem ersten Modulationsverfahren;
Erzeugen einer Vielzahl von Piloteinfügungssymbolen durch Einfügen einer Vielzahl von Pilotsymbolen in eine Vielzahl von zweiten hierarchischen Symbolen (S140);
Erzeugen einer Vielzahl von zweiten Hierarchische-Modulation-Symbolen durch Modulieren der Vielzahl von Piloteinfügungssymbolen (S150) in Übereinstimmung mit einem zweiten Modulationsverfahren; und
Erzeugen einer Vielzahl von Hierarchische-Modulation-Symbolen durch Abbilden der Vielzahl von ersten Hierarchische-Modulation-Symbolen und der Vielzahl von zweiten Hierarchische-Modulation-Symbolen in einen Signalraum (S160),

wobei das Verfahren zur hierarchischen Modulation weiterhin umfasst, eine Vielzahl von normierten Hierarchische-Modulation-Symbolen zu erzeugen (S170), die der Vielzahl von Hierarchische-Modulation-Symbolen entsprechen, indem eine Normierungskonstante auf die Vielzahl von Hierarchische-Modulation-Symbolen angewendet wird,

wobei die Vielzahl von ersten Hierarchische-Modulation-Symbolen eine Vielzahl von Basisschichtsymbolen sind, die durch Codieren einer Vielzahl von in dem Basisschichtsignal enthaltenen Bits erzeugt werden, und die Vielzahl von zweiten Hierarchische-Modulation-Symbolen eine Vielzahl von Erweiterungsschichtsymbolen sind, die durch Codieren einer Vielzahl von in dem Erweiterungsschichtsignal zum Bereitstellen dem Basisschichtsignal hinzugefügten Dienstes enthaltenen Bits erzeugt werden.

2. Verfahren zur hierarchischen Modulation nach Anspruch 1, wobei der Schritt, die Vielzahl von Piloteinfügungssymbolen zu erzeugen, umfasst, die Vielzahl von Pilotsymbolen in die Vielzahl von zweiten hierarchischen Symbolen einzufügen (S150), so dass ein Pilotsymbol an der Position mit der größten Leistung aus der Vielzahl von Hierarchische-Modulation-Symbolen bereitgestellt wird.

3. Verfahren zur hierarchischen Modulation nach Anspruch 1 wobei der Schritt, die Vielzahl von normierten Hierarchische-Modulation-Symbolen zu erzeugen (S170), umfasst, eine Vielzahl von normierten Hierarchische-Modulation-Symbolen zu erzeugen, indem die Normierungskonstante, die der Hierarchische-Modulation-Ebene der Vielzahl von Hierarchische-Modulation-Symbolen entspricht, auf die Vielzahl von Hierarchische-Modulation-Symbolen angewendet wird.

4. Verfahren zur hierarchischen Modulation nach Anspruch 1, wobei das zweite Modulationsverfahren das gleiche wie das erste Modulationsverfahren ist oder ein Phasenumtastungsverfahren ist.

5. Verfahren zur hierarchischen Modulation nach Anspruch 1, das weiterhin umfasst, die Vielzahl von ersten hierarchischen Symbolen zu erzeugen, indem eine Vielzahl von Bits, die in der ersten Hierarchisches-Signal-Sequenz enthalten sind, in Übereinstimmung mit einem ersten Codierungsverfahren codiert werden.

6. Verfahren zur hierarchischen Modulation nach Anspruch 1, das weiterhin umfasst, die Vielzahl von zweiten hierarchischen Symbolen zu erzeugen, indem eine Vielzahl von Bits, die in der zweiten Hierarchisches-Signal-Sequenz enthalten sind, in Übereinstimmung mit einem zweiten Codierungsverfahren codiert werden.

7. Vorrichtung zur hierarchischen Modulation, umfassend:

einen ersten hierarchischen Kanalcodierer (110) zum Ausgeben einer ersten Hierarchisches-Symbol-Sequenz durch Codieren der ersten Hierarchisches-Signal-Sequenz in Übereinstimmung mit einem ersten Codierungsverfahren;

einen zweiten hierarchischen Kanalcodierer (120) zum Ausgeben einer zweiten Hierarchisches-Symbol-Sequenz durch Codieren der zweiten Hierarchisches-Signal-Sequenz in Übereinstimmung mit einem zweiten Codierungsverfahren;

einen Piloteinfüger (130) zum Ausgeben einer Piloteinfügungssymbol-Sequenz durch Einfügen eines Pilotsymbols in die zweite Hierarchisches-Symbol-Sequenz; und

einen hierarchischen Modulator (150) zum Ausgeben eines Hierarchische-Modulation-Signals mittels Durchführung von hierarchischer Modulation an der ersten Hierarchisches-Symbol-Sequenz und der Piloteinfügungssymbol-Sequenz,

wobei die Vorrichtung zur hierarchischen Modulation weiterhin einen Hierarchische- Modulation- Ebene- Kontroller (140) zum Ausgeben einer Normierungskonstante

entsprechend einer Hierarchische-Modulation-Ebene enthält,

wobei der hierarchisch Modulator (150) dafür eingerichtet ist, mittels Durchführung von hierarchischen Modulation an der ersten Hierarchisches-Symbol-Sequenz und der Piloteinfügungssymbol-Sequenz auf Basis der Normierungskonstante ein normiertes Hierarchische-Modulation-Signal auszugeben, und

wobei die erste Hierarchisches-Symbol-Sequenz eine Basisschichtsymbol-Sequenz ist, die durch Codieren einer Vielzahl von in dem Basisschichtsignal enthaltenen Bits erzeugt wird, und die zweite Hierarchisches-Symbol-Sequenz eine Erweiterungsschichtsymbol-Sequenz ist, die durch Codieren einer Vielzahl von in dem Erweiterungsschichtsignal zum Bereitstellen dem Basisschichtsignal hinzugefügten Dienstes enthaltenen Bits erzeugt wird.

**8.** Vorrichtung zur hierarchischen Modulation nach Anspruch 7, wobei der hierarchischen Modulator (150) enthält:

einen ersten hierarchischen Modulator (151) zum Ausgeben einer ersten Hierarchische- Modulation- Symbol- Sequenz durch Modulieren der ersten Hierarchisches- Symbol- Sequenz in Übereinstimmung mit einem ersten Modulationsverfahren;
einen zweiten hierarchischen Modulator (153) zum Ausgeben einer zweiten Hierarchische- Modulation- Symbol- Sequenz durch Modulieren der Piloteinfügungssymbol- Sequenz in übereinstimmung mit einem zweiten Modulationsverfahren;
einen Symbolabbilder (155) zum Ausgeben eines Hierarchische- Modulation- Signals durch Abbilden der ersten Hierarchische- Modulation- Symbol- Sequenz und der zweiten Hierarchische- Modulation- Symbol- Sequenz in den Signalraum; und
einen Normierer (157) zum Ausgeben des normierten Hierarchische-Modulation-Signals durch Anwendet der Normierungskonstante auf das Hierarchische-Modulation-Signal.

**Revendications**

**1.** Procédé de modulation hiérarchique comprenant :

la génération d'une pluralité de premiers symboles de modulation hiérarchique en modulant une pluralité des premiers symboles hiérarchiques (S120) selon un premier procédé de modulation ;
la génération d'une pluralité de symboles d'insertion de pilote en insérant une pluralité de symboles pilotes dans une pluralité de seconds symboles hiérarchiques (S140) ;
la génération d'une pluralité de seconds symboles de modulation hiérarchique en modulant la pluralité de symboles d'insertion de pilote (S150) selon un second procédé de modulation ; et
la génération d'une pluralité de symboles de modulation hiérarchique en mappant la pluralité de premiers symboles de modulation hiérarchique et la pluralité de seconds symboles de modulation hiérarchique dans un espace de signal (S160),
le procédé de modulation hiérarchique comprenant en outre la génération d'une pluralité de symboles de modulation hiérarchique normalisés (S170) qui correspondent à la pluralité de symboles de modulation hiérarchique en appliquant une constante de normalisation à la pluralité de symboles de modulation hiérarchique,
dans lequel la pluralité de premiers symboles hiérarchiques est une pluralité de symboles de couche de base qui sont générés en codant une pluralité de bits compris dans le signal de couche de base, et la pluralité de seconds symboles hiérarchiques est une pluralité de symboles de couche à enrichissement qui sont générés en codant une pluralité de bits compris dans le signal de couche à enrichissement pour fournir un service ajouté au signal de couche de base.

**2.** Procédé de modulation hiérarchique selon la revendication 1, dans lequel l'étape de génération de la pluralité de symboles d'insertion de pilote comprend l'insertion de la pluralité de symboles pilotes dans la pluralité de seconds symboles hiérarchiques (S150) de sorte qu'un symbole pilote soit pourvu au niveau de la position ayant la plus grande puissance parmi la pluralité de symboles de modulation hiérarchique.

**3.** Procédé de modulation hiérarchique selon la revendication 1, dans lequel l'étape de génération de la pluralité de symboles de modulation hiérarchique normalisés (S170) comprend la génération d'une pluralité de symboles de modulation hiérarchique normalisés en appliquant la constante de normalisation qui correspond au niveau de modulation hiérarchique de la pluralité de symboles de modulation hiérarchique à la pluralité de symboles de modulation hiérarchique.

**4.** Procédé de modulation hiérarchique selon la revendication 1, dans lequel le second procédé de modulation est le même que le premier procédé de modulation ou est un procédé de modulation par déplacement de phase.

**5.** Procédé de modulation hiérarchique selon la revendication 1, comprenant en outre la génération de la pluralité de premiers symboles hiérarchiques en codant une pluralité de bits compris dans la première séquence de signal hiérarchique selon un premier procédé de codage.

**6.** Procédé de modulation hiérarchique selon la revendication 1, comprenant en outre la génération de la pluralité de seconds symboles hiérarchiques en codant une pluralité de bits compris dans la seconde séquence de signal hiérarchique selon un second procédé de codage.

**7.** Dispositif de modulation hiérarchique comprenant :

un premier codeur de canal hiérarchique (110) pour sortir une première séquence de symboles hiérarchiques en codant la première séquence de signal hiérarchique selon un premier procédé de codage ;

un second codeur de canal hiérarchique (120) pour sortir une seconde séquence de symboles hiérarchiques en codant la seconde séquence de signal hiérarchique selon un second procédé de codage ;

un dispositif d'insertion de pilote (130) pour sortir une séquence de symboles d'insertion de pilote en insérant un symbole pilote dans la seconde séquence de symboles hiérarchiques ; et

un modulateur hiérarchique (150) pour sortir un signal de modulation hiérarchique en effectuant une modulation hiérarchique sur la première séquence de symboles hiérarchiques et la séquence de symboles d'insertion de pilote,

le dispositif de modulation hiérarchique comprenant en outre un dispositif de commande de niveau de modulation hiérarchique (140) pour sortir une constante de normalisation correspondant à un niveau de modulation hiérarchique,

dans lequel le modulateur hiérarchique (150) est adapté pour sortir un signal de modulation hiérarchique normalisé en effectuant une modulation hiérarchique sur la première séquence de symboles hiérarchiques et la séquence de symboles d'insertion de pilote sur la base de la constante de normalisation, et

dans lequel la première séquence de symboles hiérarchiques est une séquence de symboles de couche de base qui est générée en codant une pluralité de bits compris dans le signal de couche de base, et la seconde séquence de symboles hiérarchiques est une séquence de symboles de couche à enrichissement qui est générée en codant une pluralité de bits compris dans le signal de couche à enrichissement pour fournir un service ajouté au signal de couche de base.

**8.** Dispositif de modulation hiérarchique selon la revendication 7, dans lequel le modulateur hiérarchique (150) comprend :

un premier modulateur hiérarchique (151) pour sortir une première séquence de symboles de modulation hiérarchique en modulant la première séquence de symboles hiérarchiques selon un premier procédé de modulation ;

un second modulateur hiérarchique (153) pour sortir une seconde séquence de symboles de modulation hiérarchique en modulant la séquence de symboles d'insertion de pilote selon un second procédé de modulation ;

un dispositif de mappage de symbole (155) pour sortir un signal de modulation hiérarchique en mappant la première séquence de symboles de modulation hiérarchique et la seconde séquence de symboles de modulation hiérarchique dans l'espace de signal ; et

un dispositif de normalisation (157) pour sortir le signal de modulation hiérarchique normalisé en appliquant la constante de normalisation au signal de modulation hiérarchique.

[Fig. 1]

```
Base layer
signal        →   ┌─────────────────┐ 110
sequence          │   Base Layer    │
                  │ Channel Encoder │───────────────────────→ ┌──────────────┐ 150
                  └─────────────────┘                         │              │
                                                              │    Layer     │ →
Enhancement       ┌─────────────────┐                         │  Modulator   │
layer signal  →   │   Enhancement   │   ┌──────────────┐      │              │
sequence          │ Layer Channel   │──→│Pilot Inserter│─────→└──────────────┘
                  │    Encoder      │   └──────────────┘            ↑
                  └─────────────────┘         130           ┌──────────────┐
                        120                                 │  Hierarchical │
                                                            │Modulation Level│
                                                            │  Controller   │
                                                            └──────────────┘
                                                                  140
```

[Fig. 2]

```
                  150    151            155         157
Base layer        ┌──────────────────────────────────────────────┐
signal        →   │   ┌─────────────┐                              │
sequence          │   │ Base Layer  │──→ ┌────────┐   ┌──────────┐ │
                  │   │  Modulator  │    │ Symbol │   │          │ │
                  │   └─────────────┘    │ Mapper │──→│Normalizer│─┼→
Enhancement       │   ┌─────────────┐ ┌─→│        │   │          │ │
layer signal  →   │   │ Enhancement │ │  └────────┘   └──────────┘ │
sequence          │   │Layer Modulator│─┘                  ↑       │
                  │   └─────────────┘                      │       │
                  └────────────────────────────────────────┼──────┘
                           153                              │
                                                    Normalization
                                                      constant
```

[Fig. 3]

```
     320           330           340         350              360
      |             |             |           |                |
 ┌──────────┐  ┌──────────┐  ┌──────────┐  ┌──────────────┐  ┌──────────────┐
 │ Channel  │  │ Equalize │  │Hierarchical│ │ Base Layer   │  │ Base Layer   │──▶
→│ Estimator│─▶│ channel  │─▶│ Separator │─▶│ Demodulator  │─▶│Channel Decoder│
 └──────────┘  └──────────┘  └──────────┘  └──────────────┘  └──────────────┘
      ▲                                   ┌──────────────┐  ┌──────────────┐
 ┌──────────┐                            │ Enhancement  │  │ Enhancement  │──▶
 │ Channel  │                          ─▶│    Layer     │─▶│Channel Decoder│
 │Estimation Info│  ～ 310                │ Demodulator  │  └──────────────┘
 │   Unit   │                            └──────────────┘          
 └──────────┘                                   370              380
```

[Fig. 4]

```
            ┌────────────────────┐              ┌────────────────────┐
 S110  ～   │ Encode base layer  │              │ Encode enhancement │   ～ S130
            │     channel        │              │   layer channel    │
            └────────────────────┘              └────────────────────┘
                      │                                    │
            ┌────────────────────┐              ┌────────────────────┐
 S120  ～   │ Modulate base layer│              │ Insert pilot symbol│   ～ S140
            └────────────────────┘              └────────────────────┘
                      │                                    │
                      │                         ┌────────────────────┐
                      │                         │     Modulate       │   ～ S150
                      │                         │ enhancement layer  │
                      │                         └────────────────────┘
                      │                                    │
                      └──────────────┬─────────────────────┘
                            ┌────────────────────┐
                            │    Map symbol      │   ～ S160
                            └────────────────────┘
                                     │
                            ┌────────────────────┐
                            │     Normalize      │   ～ S170
                            └────────────────────┘
```

[Fig. 5]

(a)

(b)

[Fig. 6]

| Base layer signal modulation method | Enhancement layer signal modulation method | $\alpha$ | Normalization constant |
|---|---|---|---|
| $\pi/4$-DQPSK | QPSK or $\pi/4$-DQPSK | 2 | $c = z/\sqrt{20}$ |
| | | 2.5 | $c = z/\sqrt{26.5}$ |
| | | 3 | $c = z/\sqrt{34}$ |
| | | 3.5 | $c = z/\sqrt{42.5}$ |

[Fig. 7]

[Fig. 8]

```
        ┌─────────────────────┐
        │  Estimate channel   │ ～ S310
        └─────────────────────┘
                  │
        ┌─────────────────────┐
        │  Equalize channel   │ ～ S320
        └─────────────────────┘
                  │
        ┌─────────────────────┐
        │   Separate layer    │ ～ S330
        └─────────────────────┘
           │              │
S340 ┌──────────────┐  ┌──────────────────┐ S360
     │ Demodulate   │  │   Demodulate     │
     │  base layer  │  │ enhancement layer│
     └──────────────┘  └──────────────────┘
           │              │
S350 ┌──────────────┐  ┌──────────────────┐ S370
     │ Decode base  │  │     Decode       │
     │    layer     │  │ enhancement layer│
     └──────────────┘  └──────────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Coherent Detection for T-DMB Receivers in Hierarchical Modulation Mode. **JI-HYUN KIM et al.** IEEE TRANSACTIONS ON CONSUMER ELECTRONICS. IEEE SERVICE CENTER, 01 May 2007, vol. 53, 294-299